# EUROPEAN PATENT SPECIFICATION

(11) **EP 3 809 594 B1**
(45) Date of publication and mention of the grant of the patent: **26.10.2022**
(21) Application number: 18922591.5
(22) Date of filing: 15.06.2018
(51) Int. Cl.: H03K 5/156

(54) **REFERENCE CLOCK DUTY RATIO CALIBRATION CIRCUIT**
KALIBRIERUNGSSCHALTUNG FÜR REFERENZTAKTTASTVERHÄLTNIS
CIRCUIT D'ÉTALONNAGE DE FACTEUR DE MARCHE D'HORLOGE DE RÉFÉRENCE

(43) Date of publication of application: 21.04.2021
(73) Proprietor: HUAWEI TECHNOLOGIES CO., LTD., Shenzhen, Guangdong 518129 (CN)
(72) Inventor: YANG, Yi, Shenzhen, Guangdong 518129 (CN); MIN, Qing, Shenzhen, Guangdong 518129 (CN); CHEN, Donghai, Shenzhen, Guangdong 518129 (CN)
(74) Representative: Gill Jennings & Every LLP
(86) International application number: PCT/CN2018/091691
(87) International publication number: WO 2019/237366

(56) References cited:
- CN-A- 106 656 122
- CN-A- 106 961 261
- US-A1- 2013 063 191
- US-A1- 2014 125 390
- US-A1- 2014 125 390
- US-B1- 9 882 570
- US-B2- 8 471 644

## Description

### TECHNICAL FIELD

This application relates to the circuit field, and in particular, to a reference clock duty cycle calibration circuit.

### BACKGROUND

In modern communication, wireless communications technologies are dominant, such as terminal wireless communications, short-range wireless communications, and large public network wireless communications. With the development of wireless communications, there are increasingly high requirements for data transmission quality and a data transmission speed.

To improve the data transmission quality and the data transmission speed, higher radio frequency bandwidth (being improved to 160 MHz), more multiple-input multiple-output (multiple input multiple output, MIMO), and higher-order modulation are proposed in the 802.11ac standard. This requires that an RMS EVM of a transmitter reaches -32 dB. When transmitter linearity meets a requirement, phase noise from a phase-locked loop is mainly limited. Noise of a reference clock is one of main sources of phase noise of a current PLL. Therefore, reducing the noise of the reference clock is necessary for improving communication performance.

US 2013/063191 A1 discloses a duty-cycle correction circuit that calibrates the duty cycle of a periodic input signal. The correction circuit includes a state machine that samples the input signal using a sample signal of a sample period. The sample period is selected to scan a period of the input signal over a number of sample periods. The resultant difference between the number of high and low samples provides a measure of the duty cycle deviation from e.g. 50%. An adjustable delay circuit adjusts the relative timing of the rising and falling edges of the input signal, and thus the duty cycle, responsive to the measure of duty cycle.

### SUMMARY

Embodiments of the present invention disclose a reference clock duty cycle calibration circuit. When the circuit is used, noise of a reference clock can be effectively reduced, and communication performance can be improved.

According to a first aspect, an embodiment of the present invention provides a reference clock duty cycle calibration circuit, including: a first low-noise low-dropout regulator, configured to provide a low-noise voltage; an oscillation circuit, configured to generate a sine wave signal under the driving of the low-noise voltage; a duty cycle adjustment circuit, configured to adjust a duty cycle of a first reference clock signal based on a first reference voltage and the sine wave signal; and a duty cycle calibration circuit including: a duty cycle detection circuit, configured to: detect the duty cycle of the first reference clock signal, and adjust an amplitude of an output signal of the duty cycle detection circuit based on the duty cycle of the first reference clock signal; and a second low-noise low-dropout regulator, configured to adjust and output the first reference voltage based on the amplitude of the output signal of the duty cycle detection circuit, where a value of the first reference voltage is directly proportional to the amplitude of the output signal of the duty cycle detection circuit. The sine wave signal generated by the oscillation circuit driven by the low-noise voltage is characterized by low noise, so that an output signal of the reference clock duty cycle calibration circuit is also characterized by low noise, thereby effectively reducing noise of a reference clock and improving communication performance.

In a feasible embodiment, the sine wave signal generated by the oscillation circuit is input to the duty cycle adjustment circuit through direct current coupling.

In a feasible embodiment, that the duty cycle detection circuit adjusts the amplitude of the output signal of the duty cycle detection circuit based on the duty cycle of the first reference clock signal includes:
the duty cycle detection circuit is configured to detect whether the duty cycle of the first reference clock signal deviates from a preset duty cycle; and
the duty cycle detection circuit is further configured to: when determining that the duty cycle of the first reference clock signal deviates from the preset duty cycle, adjust the amplitude of the output signal of the duty cycle detection circuit; and when determining that the duty cycle of the first reference clock signal does not deviate from the preset duty cycle, skip adjusting the amplitude of the output signal of the duty cycle detection circuit.

In a feasible embodiment, that the duty cycle detection circuit is configured to: when the duty cycle of the first reference clock signal deviates from the preset duty cycle, adjust the amplitude of the output signal of the duty cycle detection circuit specifically includes:
when detecting, for N consecutive times, that the duty cycle of the first reference clock signal is greater than the preset duty cycle, the duty cycle detection circuit increases the amplitude of the output signal of the duty cycle detection circuit, where N is an integer greater than 1; and
when detecting, for M consecutive times, that the duty cycle of the first reference clock signal is less than the preset duty cycle, the duty cycle detection circuit decreases the amplitude of the output signal of the duty cycle detection circuit, where M is an integer greater than 1. Because the value of the first reference voltage is directly proportional to the amplitude of the output signal of the duty cycle detection circuit, the first reference voltage may be adjusted by adjusting the amplitude of the output signal of the duty cycle detection circuit, so that the duty cycle adjustment circuit adjusts the duty cycle of the first reference clock signal, thereby dynamically adjusting a duty cycle of the output signal of the reference clock duty cycle calibration circuit.

In a feasible embodiment, that the duty cycle detection circuit obtains the duty cycle of the first reference clock signal includes:
the duty cycle detection circuit is configured to obtain high-level duration or low-level duration of the first reference clock signal; and
the duty cycle detection circuit is configured to determine the duty cycle of the first reference clock signal based on a period of the first reference clock signal and the high-level duration or the low-level duration of the first reference clock signal.

In a feasible embodiment, the preset duty cycle is 50%.

In a feasible embodiment, the duty cycle calibration circuit further includes:
a digital-to-analog conversion circuit, configured to: convert the output signal of the duty cycle detection circuit into a second reference voltage, and input the second reference voltage to the second low-noise low-dropout regulator, to adjust the first reference voltage output by the second low-noise low-dropout regulator.

In a feasible embodiment, the duty cycle adjustment circuit includes a first transistor Q1 and a second transistor Q2; where
a source of the first transistor Q1 is coupled to the duty cycle calibration circuit, both a gate of the first transistor Q1 and a gate of the second transistor Q2 are coupled to the oscillation circuit, both a drain of the first transistor Q1 and a drain of the second transistor Q2 are coupled to the duty cycle calibration circuit, and a source of the second transistor Q2 is coupled to ground; and
when a source voltage of the first transistor Q1 increases, the duty cycle of the first reference clock signal decreases, and when the source voltage of the first transistor Q2 decreases, the duty cycle of the first reference clock signal increases.

In a feasible embodiment, the reference clock duty cycle calibration circuit further includes:
a frequency doubling circuit, configured to convert the first reference clock signal into a second reference clock signal, where a frequency of the second reference clock signal is twice that of the first reference signal.

It may be learned that, in the solution in the embodiments of the present invention, the duty cycle detection circuit of the reference clock duty cycle calibration circuit detects a duty cycle of a reference clock signal output by the duty cycle adjustment circuit, and when determining that the duty cycle of the reference clock signal deviates from the preset duty cycle, the duty cycle detection circuit adjusts the amplitude of the output signal of the duty cycle detection circuit, so that an output voltage of the digital-to-analog conversion circuit changes. The output voltage of the digital-to-analog conversion circuit is a reference voltage of the second low-noise regulator, and an output voltage of the second low-noise low-dropout regulator is directly proportional to the reference voltage of the second low-noise low-dropout regulator, the output voltage of the second low-noise low-dropout regulator changes with an output voltage of the duty cycle detection circuit. In addition, because the duty cycle of the reference clock signal output by the duty cycle adjustment circuit is inversely proportional to a reference voltage of the duty cycle detection circuit, and the output voltage of the second low-noise low-dropout regulator is a reference voltage of the duty cycle adjustment circuit, the duty cycle of the reference clock signal output by the duty cycle adjustment circuit may be adjusted by adjusting the output voltage of the second low-noise low-dropout regulator. When the reference clock duty cycle calibration circuit in the present invention is used, the noise of the reference clock can be effectively reduced, and communication performance can be improved.

### BRIEF DESCRIPTION OF DRAWINGS

To describe the technical solutions in the embodiments of the present invention more clearly, the following briefly describes the accompanying drawings for describing the embodiments or the prior art. Apparently, the accompanying drawings in the following descriptions show merely some embodiments of the present invention, and a person of ordinary skill in the art may still derive other accompanying drawings from these accompanying drawings without creative efforts.
FIG. 1 is a schematic diagram of a reference clock duty cycle calibration circuit according to an embodiment of the present invention;
FIG. 2 is a schematic diagram of a structure and a working principle of a duty cycle adjustment circuit according to an embodiment of the present invention;
FIG. 3a is a schematic structural diagram of a duty cycle detection circuit according to an embodiment of the present invention;
FIG. 3b is a schematic diagram of a signal flow of a duty cycle detection circuit in a mode 1 according to an embodiment of the present invention;
FIG. 3c is a schematic diagram of a signal flow of a duty cycle detection circuit in a mode 2 according to an embodiment of the present invention;
FIG. 3d is a schematic diagram of a signal flow of a duty cycle detection circuit in a mode 0 according to an embodiment of the present invention; and
FIG. 4 is a schematic diagram of a clock signal time sequence of a duty cycle detection circuit according to an embodiment of the present invention.

### DESCRIPTION OF EMBODIMENTS

The following clearly and completely describes the technical solutions in the embodiments of the present invention with reference to the accompanying drawings in the embodiments of the present invention.

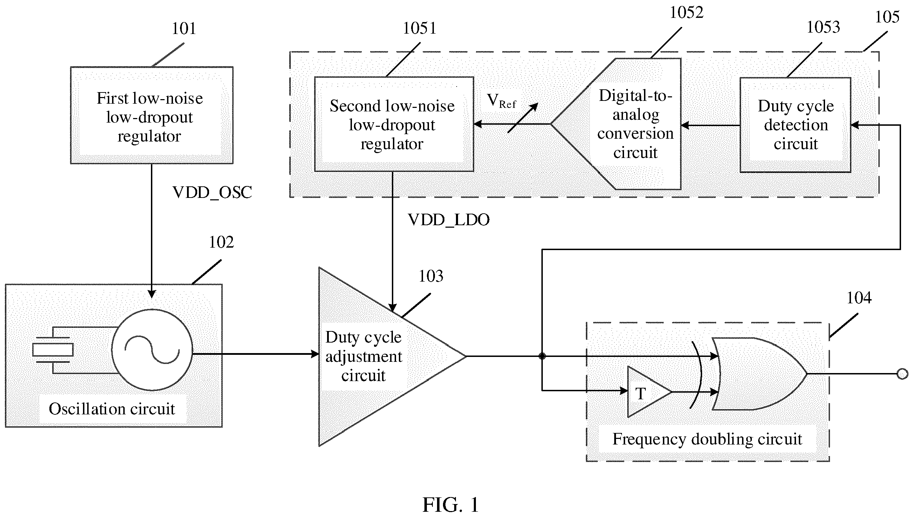

FIG. 1 is a schematic diagram of a reference clock duty cycle calibration circuit according to an embodiment of the present invention. As shown in FIG. 1, the reference clock duty cycle calibration circuit includes a first low-noise low-dropout regulator 101, an oscillation circuit 102, a duty cycle adjustment circuit 103, a frequency doubling circuit 104, and a duty cycle calibration circuit 105.

The first low-noise low-dropout regulator 101 is coupled to the oscillation circuit 102, and a sine wave signal generated by the oscillation circuit 102 is input to the duty cycle adjustment circuit 103 through direct current coupling. The duty cycle adjustment circuit 103 is coupled to the duty cycle calibration circuit 105. The duty cycle calibration circuit 105 is coupled to the duty cycle adjustment circuit 103. The duty cycle adjustment circuit 103 is coupled to the frequency doubling circuit 104.

A voltage output by the first low-noise low-dropout regulator 101 is a low-noise voltage, and this low-noise power supply is used to drive the oscillation circuit 102, so that the oscillation circuit 102 generates a clock signal. The clock signal is a sine wave signal, and the low-noise voltage output by the first low-noise low-dropout regulator 101 is a direct current voltage. The oscillation circuit 102 inputs the generated clock signal to the duty cycle adjustment circuit 103, and the duty cycle adjustment circuit 103 adjusts, based on a first reference voltage provided by a second low-noise low-dropout regulator 1051 of the duty cycle calibration circuit 105, a duty cycle of a first reference clock signal generated based on the sine wave signal provided by the oscillation circuit 102. The first reference clock signal is a square wave signal. The first reference voltage is a low-noise direct current voltage with an adjustable amplitude.

The duty cycle calibration circuit 105 includes a duty cycle detection circuit 1053 and the second low-noise low-dropout regulator 1051 coupled to the duty cycle detection circuit 1053.

The duty cycle detection circuit 1053 is configured to: detect the duty cycle of the first reference clock signal, and adjust an amplitude of an output signal of the duty cycle detection circuit 1053 based on the duty cycle of the first reference clock signal.

The second low-noise low-dropout regulator is configured to adjust and output the first reference voltage based on the amplitude of the output signal of the duty cycle detection circuit, where the amplitude of the first reference voltage is directly proportional to the amplitude of the output signal of the duty cycle detection circuit.

The duty cycle calibration circuit 105 further includes:
a digital-to-analog conversion circuit 1052, configured to: convert the output signal of the duty cycle detection circuit 1053 into a second reference voltage, and input the second reference voltage to the second low-noise low-dropout regulator 1051, to adjust the first reference voltage output by the second low-noise low-dropout regulator 1051.

The second reference voltage is directly proportional to the amplitude of the output signal of the duty cycle detection circuit 1053, and the first reference voltage is directly proportional to the second reference voltage. In other words, the first reference voltage is directly proportional to the amplitude of the output signal of the duty cycle detection circuit 1053.

Specifically, the duty cycle detection circuit 1053 is configured to: when the duty cycle of the first reference clock signal deviates from a preset duty cycle, adjust the amplitude of the output signal of the duty cycle detection circuit 1053. This specifically includes:
when detecting, for N consecutive times, that the duty cycle of the first reference clock signal is greater than the preset duty cycle, the duty cycle detection circuit 1053 increases the amplitude of the output signal of the duty cycle detection circuit 1053, where N is an integer greater than 1; and
when detecting, for M consecutive times, that the duty cycle of the first reference clock signal is less than the preset duty cycle, the duty cycle detection circuit 1053 decreases the amplitude of the output signal of the duty cycle detection circuit 1053, where M is an integer greater than 1, and M is equal to or unequal to N.

Optionally, the preset duty cycle is 50%.

That the duty cycle detection circuit 1053 obtains the duty cycle of the first reference clock signal includes:
the duty cycle detection circuit 1053 obtains high-level duration or low-level duration of the first reference clock signal, and determines the duty cycle of the first reference clock signal based on a period of the first reference clock signal and the high-level duration or the low-level duration of the first reference clock signal.

The amplitude of the output signal of the duty cycle detection circuit 1053 is directly proportional to a value of the first reference voltage.

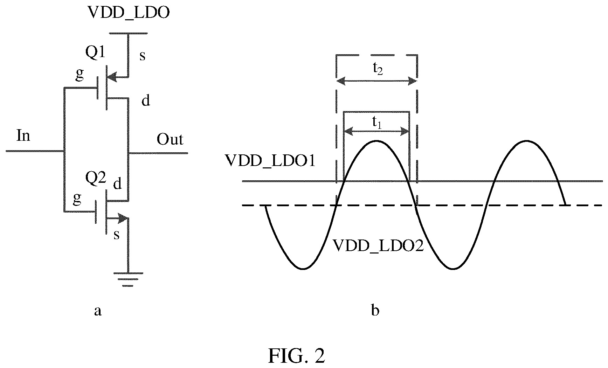

A working principle of the duty cycle adjustment circuit 103 is specifically described below. A structure of the duty cycle adjustment circuit 103 is shown in a in FIG. 2, and the duty cycle adjustment circuit includes two transistors: a first transistor Q1 and a second field effect transistor Q2. A source (s) of the first transistor Q1 is coupled to the duty cycle calibration circuit, both a gate (g) of the first transistor Q1 and a gate (g) of the second transistor Q2 are coupled to the oscillation circuit, both a drain (d) of the first transistor Q1 and a drain (d) of the second transistor Q2 are coupled to the duty cycle calibration circuit, and a source (s) of the second transistor Q2 is coupled to ground.

When a source voltage of the first transistor Q1 increases, the duty cycle of the first reference clock signal decreases, and when the source voltage of the first transistor Q2 decreases, the duty cycle of the first reference clock signal increases.

An output voltage of the second low-noise low-dropout regulator is VDD_LDO, in other words, the first reference voltage is VDD_LDO.

It should be noted that both the transistors Q1 and Q2 are metal oxide field effect transistors.

As shown in b in FIG. 2, the period of the first reference clock signal is T_{ref}. When VDD_LDO=VDD_LDO1, high-level time output by the duty cycle adjustment circuit 103 is t₁, and in this case, the duty cycle of the first reference clock signal output by the duty cycle adjustment circuit 103 is t₁/T_{ref}. When VDD_LDO=VDD_LDO2, the high-level time output by the duty cycle adjustment circuit 103 is t₂, and in this case, the duty cycle of the first reference clock signal output by the duty cycle adjustment circuit 103 is t₂/T_{ref}. It may be learned from b in FIG. 2 that t₂>t₁, and therefore t₂/T_{ref}>t₁/T_{ref}. Therefore, the duty cycle of the first reference clock signal may be adjusted by adjusting a magnitude of a direct current voltage (namely, the first reference voltage) input by the duty cycle adjustment circuit 103.

When the first reference voltage of the duty cycle adjustment circuit 103 increases, the duty cycle of the first reference clock signal output by the duty cycle adjustment circuit 103 decreases. When the first reference voltage of the duty cycle adjustment circuit 103 decreases, the duty cycle of the first reference clock signal output by the duty cycle adjustment circuit 103 increases. Therefore, it may be reversely derived that when the duty cycle detection circuit 1053 determines that the duty cycle of the first reference clock signal is greater than the preset duty cycle, the duty cycle detection circuit 1053 increases the amplitude of the output signal of the duty cycle detection circuit 1053, to increase a reference voltage (namely, the second reference voltage) of the second low-noise low-dropout regulator 1051. Because a voltage of the output signal of the second low-noise low-dropout regulator 1051 is directly proportional to the second reference voltage, the duty cycle of the first reference clock signal decreases when the reference voltage of the duty cycle adjustment circuit 103 increases. On the contrary, when the duty cycle detection circuit 1053 determines that the duty cycle of the first reference clock signal is less than the preset duty cycle, the duty cycle detection circuit 1053 decreases the amplitude of the output signal of the duty cycle detection circuit 1053, to decrease the reference voltage (namely, the second reference voltage) of the second low-noise low-dropout regulator 1051. Because the voltage of the output signal of the second low-noise low-dropout regulator 1051 is directly proportional to the second reference voltage, the reference voltage of the duty cycle adjustment circuit 103 decreases, so that the duty cycle of the first reference clock signal increases.

In a feasible embodiment, the reference clock duty cycle calibration circuit further includes the frequency doubling circuit 104, and the frequency doubling circuit 104 is coupled to the duty cycle adjustment circuit.

The frequency doubling circuit 104 includes a delay circuit and an exclusive OR gate circuit. The delay circuit is coupled to the exclusive OR gate circuit, and the delay circuit and the exclusive OR gate circuit are coupled to the duty cycle adjustment circuit.

The first reference clock signal output by the duty cycle adjustment circuit 103 simultaneously drives the frequency doubling circuit 104 and the duty cycle detection circuit 1053 of the duty cycle calibration circuit 105.

Specifically, the duty cycle adjustment circuit 103 directly inputs the output reference clock signal to the exclusive OR gate circuit and the delay circuit of the frequency doubling circuit. The delay circuit delays the reference clock signal output by the duty cycle adjustment circuit, and then inputs the delayed reference clock signal to the exclusive OR gate circuit. After the reference clock signal and the delayed reference clock signal pass through the foregoing exclusive OR gate, a reference clock signal with a doubled frequency is obtained. For example, if a frequency of the reference clock signal is f_{ref} and an amplitude is V, a frequency of the reference clock signal with the doubled frequency is f=2f_{ref} and an amplitude is V.

It should be noted that, in this application, duration in which the delay circuit delays the reference clock signal is not limited.

A structure framework and a working principle of the duty cycle detection circuit 1053 are specifically described below.

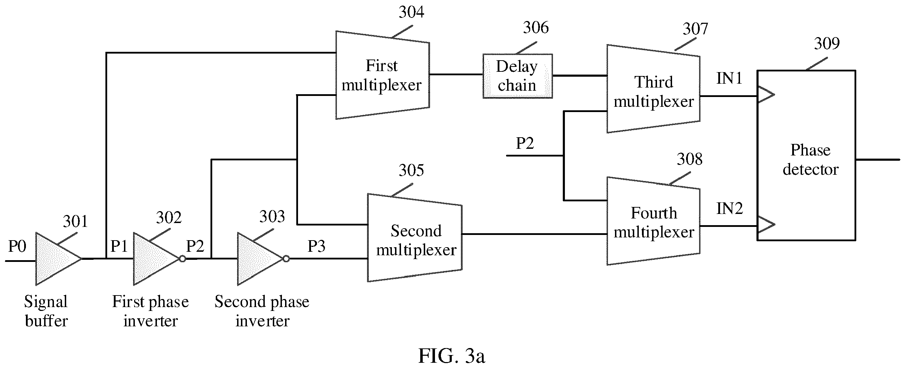

As shown in FIG. 3a, the duty cycle detection circuit 1053 includes a signal buffer 301, two phase inverters (including a first phase inverter 302 and a second phase inverter 303), four multiplexers (including a first multiplexer 304, a second multiplexer 305, a third multiplexer 307, and a fourth multiplexer 308), a delay chain 306, and a phase detector 309.

The signal buffer 301 is coupled to the first phase inverter 302 and the first multiplexer 304, the first phase inverter 302 is coupled to the second phase inverter 303, the first multiplexer 304, and the second multiplexer 305, and the second phase inverter 303 is coupled to the second multiplexer 305. The first multiplexer 304 is coupled to the delay chain 306, the delay chain 306 is coupled to the third multiplexer 307, and the second multiplexer 305 is coupled to the fourth multiplexer 308. The first phase inverter 302 is further coupled to the third multiplexer 307 and the fourth multiplexer 308. The third multiplexer 307 and the fourth multiplexer 308 are separately coupled to the phase detector 309.

A reference clock signal input to the duty cycle detection circuit 1053 (namely, the signal buffer 301) is P0. A clock signal P1 is obtained after the reference clock signal P0 passes through the signal buffer 301, and a frequency, an amplitude, and a duty cycle of the clock signal P1 are the same as those of the reference clock signal P0. A clock signal P2 is obtained after the clock signal P1 passes through the first phase inverter 302, where a frequency and an amplitude of the clock signal P2 are the same as those of the clock signal P1, but a phase of the clock signal P2 is opposite to that of the clock signal P1, and the duty cycle of the clock signal P1 is equal to 1 minus a duty cycle of the clock signal P2. A clock signal P3 is obtained after the clock signal P2 passes through the second phase inverter 303, where a frequency, an amplitude, and a duty cycle of the clock signal P3 are the same as those of the clock signal P1, but a phase of the clock signal P3 is opposite to that of the clock signal P2, in other words, the phase of the clock signal P3 is the same as that of the clock signal P1.

The duty cycle detection circuit has three working modes: a mode 1, a mode 2, and a mode 0. The mode 1 is to determine a duty cycle of an input signal by detecting time T2 in which the input signal is at a high level. The mode 2 is to detect time T1 in which the input signal is at a low level. The mode 0 is to calibrate the phase detector 309.

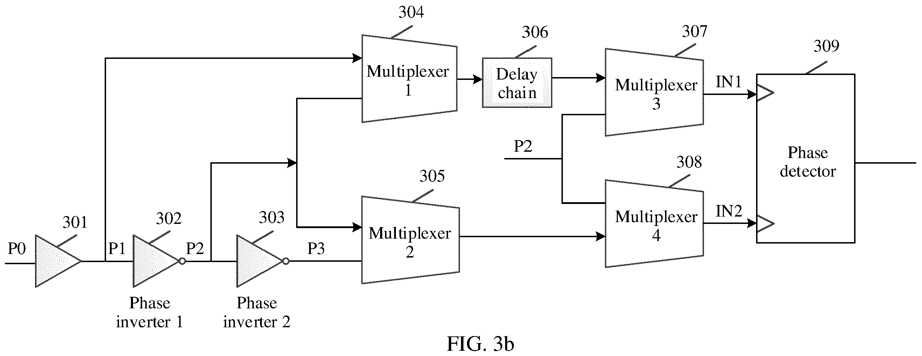

When the working mode of the duty cycle detection circuit 1053 is the mode 1, as shown in FIG. 3b, the first multiplexer 304 selects a first input signal (namely, the clock signal P1) of the first multiplexer 304, and the second multiplexer 305 selects a second input signal (namely, the clock signal P2) of the second multiplexer 305. A delayed clock signal P1 is obtained after the clock signal P1 passes through the delay chain 306. The third multiplexer 307 selects a first input signal (namely, the delayed clock signal P1) of the third multiplexer 307, in other words, a first input signal (IN1) of the phase detector 309 is the delayed clock signal P1. The fourth multiplexer 308 selects a second input signal (a signal output from the second multiplexer 305) of the fourth multiplexer 308, in other words, a second input signal (IN2) of the phase detector 309 is the signal output from the second multiplexer 305.

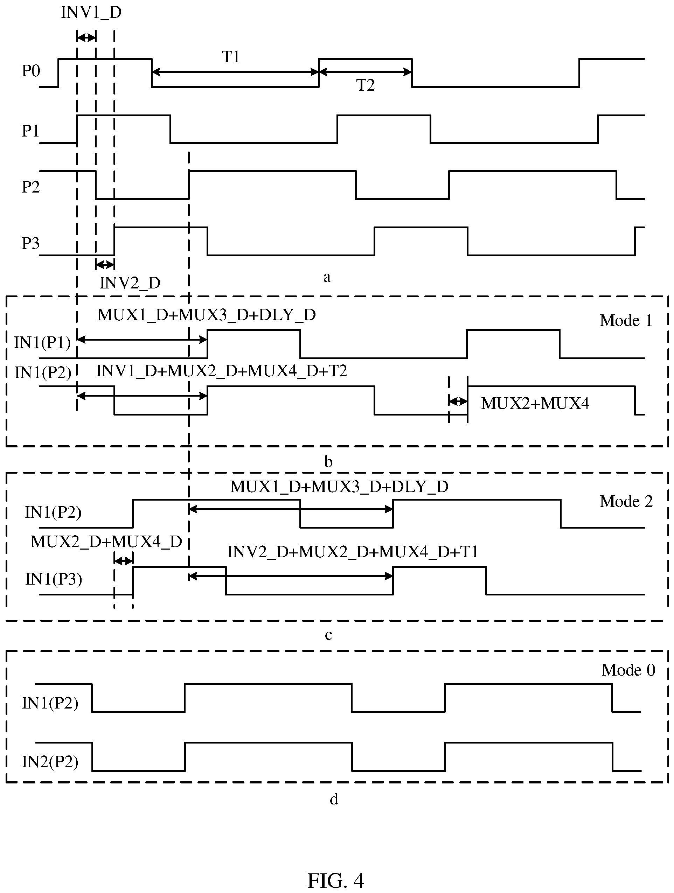

A sequence diagram of the clock signals P0, P1, P2, and P3 is shown in a in FIG. 4. A delay between the clock signal P2 and the clock signal P1 is INV1_D, in other words, a delay generated after the clock signal passes through the first phase inverter 302 is INV1_D. A delay between the clock signal P3 and the clock signal P2 is INV2_D, in other words, a delay generated after the clock signal passes through the second phase inverter 303 is INV2_D. Low-level duration of the clock signals P0, P1, and P3 is T1, and high-level duration is T2. Because the clock signal P2 is obtained after the clock signal P1 passes through the phase inverter, low-level duration of the clock signal P2 is T2, and high-level duration is T1.

When the working mode of the duty cycle detection circuit 1053 is the mode 1, time sequences of the first input signal (IN1) and the second input signal (IN2) of the phase detector 309 of the duty cycle detection circuit 1053 are shown in b in FIG. 4. Delays generated after the clock signal P1 passes through the first multiplexer 304, the delay chain 306, and the third multiplexer 307 are respectively MUX1_D, DLY_D, and MUX3_D, and delays generated after the clock signal P2 passes through the second multiplexer 305 and the fourth multiplexer 308 are respectively MUX2_D and MUX4_D. A delay generated by the delay chain 306 for the clock signal P2 is DLY_D. When a phase difference between the input signals IN1 and IN2 of the phase detector 309 is 0, a condition INV1 (a rising edge)+MXU2_D+MUX4_D+T2=MUX1_D+MUX3_D+DLY_D is met. If delays generated after the clock signal passes through the first multiplexer 304, the second multiplexer 305, the third multiplexer 307, and the fourth multiplexer 308 are equal, INV1 (the rising edge)+T2=DLY_D.

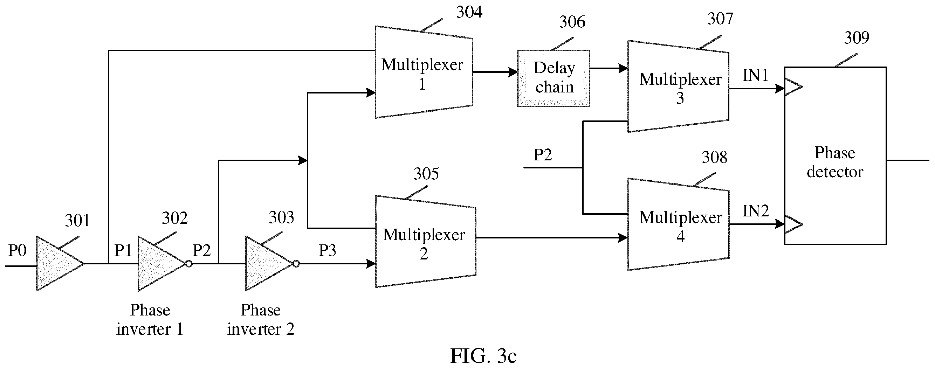

When the working mode of the duty cycle detection circuit 1053 is the mode 2, as shown in FIG. 3c, the first multiplexer 304 selects a second input signal (namely, the clock signal P2) of the first multiplexer 304, and the second multiplexer 305 selects a second input signal (namely, the clock signal P2) of the second multiplexer 305. A delayed clock signal P2 is obtained after the clock signal P2 passes through the delay chain 306. The third multiplexer 307 selects a first input signal (namely, the delayed clock signal P2) of the third multiplexer 307, in other words, a first input signal (IN1) of the phase detector 309 is the delayed clock signal P2. The fourth multiplexer 308 selects a second input signal (a signal output from the second multiplexer 305) of the fourth multiplexer 308, in other words, a second input signal (IN2) of the phase detector 309 is the signal output from the second multiplexer 305.

When the working mode of the duty cycle detection circuit 1053 is the mode 2, time sequences of the first input signal (IN1) and the second input signal (IN2) of the phase detector 309 of the duty cycle detection circuit 1053 are shown in c in FIG. 4. Delays generated after the clock signal P2 passes through the first multiplexer 304, the delay chain 306, and the third multiplexer 307 are respectively MUX1_D, DLY_D, and MUX3_D, and delays generated after the clock signal P3 passes through the second multiplexer 305 and the fourth multiplexer 308 are respectively MUX2_D and MUX4_D. A delay generated by the delay chain 306 for the clock signal P2 is DLY_D. When a phase difference between the input signals IN1 and IN2 of the phase detector 309 is 0, a condition INV2 (a rising edge)+MXU2_D+MUX4_D+T2=MUX1_D+MUX3_D+DLY_D is met. If delays generated after the clock signal passes through the first multiplexer 304, the second multiplexer 305, the third multiplexer 307, and the fourth multiplexer 308 are equal, INV2 (a rising edge)+T2=DLY_D.

In conclusion, when rising edge delays of INV1 and INV2 are equal, delay duration of the delay chain represents a relative relationship between T1 and T2. When the duty cycle of the clock signal is 50% (in other words, T1=T2), delays generated by the delay chain in the mode 1 and the mode 2 are equal.

A method for obtaining the delay duration DLY_D of the delay chain 309 by the phase detector 309 is described below.

Three bit groups including a coarse adjustment bit group, an intermediate adjustment bit group, and a fine adjustment bit group are preset for the phase detector 309. The coarse adjustment bit group includes s1 bits, the intermediate adjustment bit group includes s2 bits, and the fine adjustment bit group includes s3 bits. The phase detector 309 determines whether to perform coarse adjustment and intermediate adjustment.

When determining to perform coarse adjustment and intermediate adjustment, the phase detector 309 performs coarse adjustment. This is specifically as follows:
The phase detector 309 waits for first preset duration. Then, the phase detector 309 determines whether the rising edge of the first input signal (IN1) of the phase detector 309 is aligned with the rising edge of the second input signal (IN2), in other words, whether there is a delay difference between the first input signal (IN1) and the second input signal (IN2). When there is no delay difference between the first input signal (IN1) and the second input signal (IN2), the phase detector 309 sets a first bit in the coarse adjustment bit group to 0. When there is the delay difference between the first input signal (IN1) and the second input signal (IN2), the phase detector 309 sets the first bit in the coarse adjustment bit group to 1. Then, the phase detector 309 repeatedly performs the foregoing process for s1 times, and after the foregoing process is performed for s1 times, the s1 bits in the coarse adjustment bit group are set to 0 or 1, where s1 is an integer greater than 1. The coarse adjustment bit group may be considered as a character string including 0 and 1.

Then, the phase detector 309 performs intermediate adjustment, and an intermediate adjustment process is similar to the foregoing coarse adjustment process. This is specifically as follows:
The phase detector 309 waits for second preset duration. Then, the phase detector 309 determines whether there is a delay difference between the first input signal (IN1) and the second input signal (IN2). When there is no delay difference between the first input signal (IN1) and the second input signal (IN2), the phase detector 309 sets a first bit in the intermediate adjustment bit group to 0. When there is the delay difference between the first input signal (IN1) and the second input signal (IN2), the phase detector 309 sets the first bit in the intermediate adjustment bit group to 1. Then, the phase detector 309 repeatedly performs the foregoing process for s2 times, and after the foregoing process is performed for s2 times, the s2 bits in the coarse adjustment bit group are set to 0 or 1, where s1 is an integer greater than 1. The intermediate adjustment bit group may be considered as a character string including 0 and 1.

The phase detector 309 directly enters fine adjustment when determining to skip coarse adjustment and intermediate adjustment. A fine adjustment process is similar to the coarse adjustment process and the intermediate adjustment process. Details are not described herein.

After the phase detector 309 completes the fine adjustment process, the s3 bits in the fine adjustment bit group are set to 0 or 1. The fine adjustment bit group may be considered as a character string including 0 and 1.

After the phase detector 309 completes the foregoing coarse adjustment, intermediate adjustment, and fine adjustment, the phase detector 309 determines the delay duration of the delay chain based on the coarse adjustment bit group, the intermediate adjustment bit group, and the fine adjustment bit group. Specifically, the phase detector 309 separately obtains a quantity of bits in the coarse adjustment bit group that are set to 1, a quantity of bits in the intermediate adjustment bit group that are set to 1, and a quantity of bits in the fine adjustment bit group that are set to 1. The quantity of bits in the coarse adjustment bit group that are set to 1, the quantity of bits in the intermediate adjustment bit group that are set to 1, and the quantity of bits in the fine adjustment bit group that are set to 1 are respectively n1, n2, and n3. Delay duration represented by each bit that is set to 1 in the coarse adjustment bit group is t1 seconds, delay duration represented by each bit that is set to 1 in the intermediate adjustment bit group is t2 seconds, and delay duration represented by each bit that is set to 1 in the fine adjustment bit group is t3 seconds, where t1>t2>t3. Therefore, the phase detector 309 determines that the delay duration of the delay chain 306 is DLY_D=t1^{∗}n1+t2^{∗}n2+t3^{∗}n3.

For example, the delay duration represented by each bit that is set to 1 in the coarse adjustment bit group is 0.5 nanoseconds, the delay duration represented by each bit that is set to 1 in the intermediate adjustment bit group is 15 picoseconds, and the delay duration represented by each bit that is set to 1 in the fine adjustment bit group is 500 femtoseconds. The quantity of bits in the coarse adjustment bit group that are set to 1, the quantity of bits in the intermediate adjustment bit group that are set to 1, and the quantity of bits in the fine adjustment bit group that are set to 1 are respectively 4, 6, and 7, and the delay duration of the delay chain 306 is DLY_D=0.5 nanoseconds^{∗}4+15 picoseconds^{∗}6+500 femtoseconds^{∗}7=2.0935 nanoseconds.

Based on the foregoing method, the phase detector 309 may obtain the delay duration DLY_D of the delay chain.

Further, the duty cycle detection circuit further includes a microprocessor, and the microprocessor is configured to adjust, when the working mode is the mode 1 and the mode 2, a delay generated by the delay chain for a clock signal output by the first multiplexer 304, so that the delay difference between the first input signal and the second input signal of the phase detector 309 is 0.

Specifically, the microprocessor determines whether phases of two input signals (namely, IN1 and IN2) detected by the phase detector are 0. When the phase detector 309 determines that the phase difference between the two input signals of the phase detector 309 is not 0 and the phase of the first input signal (namely, IN1) is earlier than that of the second input signal (namely, IN2), the microprocessor increases a delay of the delay chain for the first input signal of the third multiplexer 307, to increase a delay of the first input signal (namely, IN1) of the phase detector 309, so that the phase difference between the two input signals of the phase detector 309 decreases. When the phase detector 309 determines that the phase difference between the two input signals of the phase detector 309 is not 0 and the first input signal (IN1) is later than the second input signal (IN2), the microprocessor reduces the delay of the delay chain for the first input signal of the third multiplexer 307, to reduce the delay of the first input signal (namely, IN1) of the phase detector 309, so that the phase difference between the two input signals of the phase detector 309 decreases.

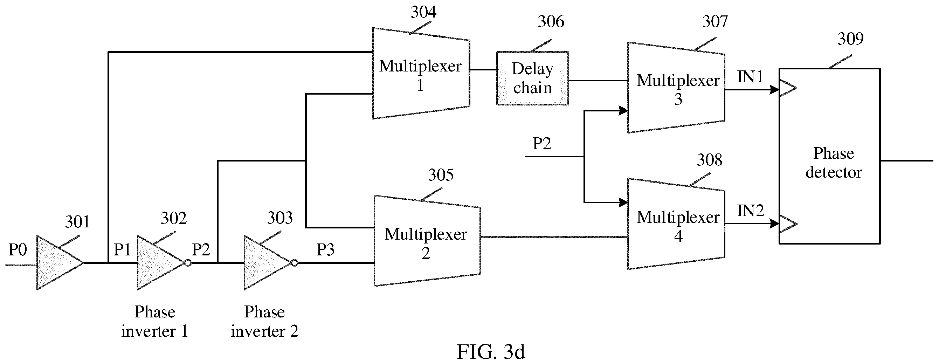

When the working mode of the duty cycle detection circuit 1053 is the mode 0, as shown in FIG. 3d, the third multiplexer 307 selects a second input signal of the third multiplexer 307, and the fourth multiplexer 308 selects a first input signal of the fourth multiplexer 308. In other words, both the first input signal and the second input signal of the phase detector 309 are P2. Because a delay of the third multiplexer 307 for P2 and a delay of the fourth multiplexer 308 for P2 are consistent, the phase difference between the two signals input to the phase detector 309 is 0. In other words, the third multiplexer 307 and the fourth multiplexer 308 select a same input signal to enter the phase detector 309. As shown in d in FIG. 4, the phase difference between the first input signal (namely, IN1) and the second input signal (namely, IN2) of the phase detector 309 is 0.

The embodiments of the present invention are described in detail above. The principle and implementation of the present invention are described herein by using specific examples. The description about the embodiments of the present invention is merely provided to help understand the method and core ideas of the present invention. In addition, a person of ordinary skill in the art can make variations and modifications to the present invention in terms of the specific implementations and application scopes based on the scope of the claims. Therefore, the content of specification shall not be construed as a limit to the present invention.

## Claims

1. A reference clock duty cycle calibration circuit, comprising:
a first low-noise low-dropout regulator (101), configured to provide a low-noise voltage;
an oscillation circuit (102), configured to generate a sine wave signal under the driving of the low-noise voltage;
a duty cycle adjustment circuit (103), configured to adjust, based on a first reference voltage, a duty cycle of a first reference clock signal generated based on the sine wave signal; and
a duty cycle calibration circuit (105), comprising:
a duty cycle detection circuit (1053), configured to detect the duty cycle of the first reference clock signal, and adjust an amplitude of an output signal of the duty cycle detection circuit based on the duty cycle of the first reference clock signal; and
a second low-noise low-dropout regulator (1051), configured to adjust and output the first reference voltage based on the amplitude of the output signal of the duty cycle detection circuit, wherein a value of the first reference voltage is directly proportional to the amplitude of the output signal of the duty cycle detection circuit.

2. The circuit according to claim 1, wherein the sine wave signal generated by the oscillation circuit is input to the duty cycle adjustment circuit through direct current coupling.

3. The circuit according to claim 1 or 2, wherein that the duty cycle detection circuit adjusts the amplitude of the output signal of the duty cycle detection circuit based on the duty cycle of the first reference clock signal comprises:
the duty cycle detection circuit is configured to detect whether the duty cycle of the first reference clock signal deviates from a preset duty cycle; and
the duty cycle detection circuit is further configured to: when determining that the duty cycle of the first reference clock signal deviates from the preset duty cycle, adjust the amplitude of the output signal of the duty cycle detection circuit; and when determining that the duty cycle of the first reference clock signal does not deviate from the preset duty cycle, skip adjusting the amplitude of an output signal of the duty cycle detection circuit.

4. The circuit according to claim 3, wherein that the duty cycle detection circuit is configured to: when the duty cycle of the first reference clock signal deviates from the preset duty cycle, adjust the amplitude of the output signal of the duty cycle detection circuit specifically comprises:
when detecting, for N consecutive times, that the duty cycle of the first reference clock signal is greater than the preset duty cycle, increasing, by the duty cycle detection circuit, the amplitude of the output signal of the duty cycle detection circuit, wherein N is an integer greater than 1.

5. The circuit according to claim 3, wherein that the duty cycle detection circuit is configured to: when the duty cycle of the first reference clock signal deviates from the preset duty cycle, adjust the amplitude of the output signal of the duty cycle detection circuit specifically comprises:
when detecting, for M consecutive times, that the duty cycle of the first reference clock signal is less than the preset duty cycle, decreasing, by the duty cycle detection circuit, the amplitude of the output signal of the duty cycle detection circuit, wherein M is an integer greater than 1.

6. The circuit according to claim 4 or 5, wherein that the duty cycle detection circuit obtains the duty cycle of the first reference clock signal comprises:
the duty cycle detection circuit is configured to obtain high-level duration or low-level duration of the first reference clock signal; and
the duty cycle detection circuit is configured to determine the duty cycle of the first reference clock signal based on a period of the first reference clock signal and the high level duration or the low level duration of the first reference clock signal.

7. The circuit according to any one of claims 3 to 5, wherein the preset duty cycle is 50%.

8. The circuit according to claim 3, wherein the duty cycle calibration circuit further comprises:
a digital-to-analog conversion circuit (1052), configured to: convert the output signal of the duty cycle detection circuit into a second reference voltage, and input the second reference voltage to the second low-noise low-dropout regulator, to adjust the first reference voltage output by the second low-noise low-dropout regulator.

9. The circuit according to any one of claims 1 to 8, wherein the duty cycle regulating circuit comprises a first transistor Q1 and a second transistor Q2;
a source of the first transistor Q1 is coupled to the duty cycle calibration circuit, both a gate of the first transistor Q1 and a gate of the second transistor Q2 are coupled to the oscillation circuit, both a drain of the first transistor Q1 and a drain of the second transistor Q2 are coupled to the duty cycle calibration circuit, and a source of the second transistor Q2 is coupled to the ground; and
when a source voltage of the first transistor Q1 increases, the duty cycle of the first reference clock signal decreases, and when the source voltage of the first transistor Q1 decreases, the duty cycle of the first reference clock signal increases.

10. The circuit according to any one of claims 1 to 9, wherein the duty cycle calibration circuit further comprises:
a frequency doubling circuit, configured to convert the first reference clock signal into a second reference clock signal, wherein a frequency of the second reference clock signal is twice that of the first reference clock signal.

## Patentansprüche

1. Referenztakt-Tastverhältnis-Kalibrationsschaltung, umfassend:
einen ersten rauscharmen abfallarmen Regler (101), ausgelegt zum Bereitstellen einer rauscharmen Spannung;
eine Oszillationsschaltung (102), ausgelegt zum Erzeugen eines Sinuswellensignals unter der Ansteuerung der rauscharmen Spannung;
eine Tastverhältnis-Einstellschaltung (103), ausgelegt zum Einstellen eines Tastverhältnisses eines auf der Basis des Sinuswellensignals erzeugten ersten Referenztaktsignals auf der Basis einer ersten Referenzspannung; und
eine Tastverhältnis-Kalibrationsschaltung (105), umfassend:
eine Tastverhältnis-Detektionsschaltung (1053), ausgelegt zum Detektieren des Tastverhältnisses des ersten Referenztaktsignals und Einstellen einer Amplitude eines Ausgangssignals der Tastverhältnis-Detektionsschaltung auf der Basis des Tastverhältnisses des ersten Referenztaktsignals; und
einen zweiten rauscharmen, abfallarmen Regler (1051), ausgelegt zum Einstellen und Ausgeben der ersten Referenzspannung auf der Basis der Amplitude des Ausgangssignals der Tastverhältnis-Detektionsschaltung, wobei ein Wert der ersten Referenzspannung direkt proportional zu der Amplitude des Ausgangssignals der Tastverhältnis-Detektionsschaltung ist.

2. Schaltung nach Anspruch 1, wobei das durch die Oszillationsschaltung erzeugte Sinuswellensignal mittels Gleichspannungskopplung in die Tastverhältnis-Einstellungsschaltung eingegeben wird.

3. Schaltung nach Anspruch 1 oder 2, wobei, dass die Tastverhältnis-Detektionsschaltung die Amplitude des Ausgangssignals der Tastverhältnis-Detektionsschaltung auf der Basis des Tastverhältnisses des ersten Referenztaktsignals einstellt, Folgendes umfasst:
die Tastverhältnis-Detektionsschaltung ist ausgelegt zum Detektieren, ob das Tastverhältnis des ersten Referenztaktsignals von einem voreingestellten Tastverhältnis abweicht; und
die Tastverhältnis-Detektionsschaltung ist ferner für Folgendes ausgelegt: wenn bestimmt wird, dass das Tastverhältnis des ersten Referenztaktsignals von dem voreingestellten Tastverhältnis abweicht, Einstellen der Amplitude des Ausgangssignals der Tastverhältnis-Detektionsschaltung; und wenn bestimmt wird, dass das Tastverhältnis des ersten Referenztaktsignals nicht von dem voreingestellten Tastverhältnis abweicht, Überspringen des Einstellens der Amplitude eines Ausgangssignals der Tastverhältnis-Detektionsschaltung.

4. Schaltung nach Anspruch 3, wobei, dass die Tastverhältnis-Detektionsschaltung für Folgendes ausgelegt ist: wenn das Tastverhältnis des ersten Referenztaktsignals von dem voreingestellten Tastverhältnis abweicht, Einstellen der Amplitude des Ausgangssignals der Tastverhältnis-Detektionsschaltung, speziell Folgendes umfasst: wenn N aufeinanderfolgende Male detektiert wird, dass das Tastverhältnis des ersten Referenztaktsignals größer als das voreingestellte Tastverhältnis ist, Vergrößern der Amplitude des Ausgangssignals der Tastverhältnis-Detektionsschaltung durch die Tastverhältnis-Detektionsschaltung, wobei N eine ganze Zahl größer als 1 ist.

5. Schaltung nach Anspruch 3, wobei, dass die Tastverhältnis-Detektionsschaltung für Folgendes ausgelegt ist: wenn das Tastverhältnis des ersten Referenztaktsignals von dem voreingestellten Tastverhältnis abweicht, Einstellen der Amplitude des Ausgangssignals der Tastverhältnis-Detektionsschaltung, speziell Folgendes umfasst: wenn M aufeinanderfolgende Male detektiert wird, dass das Tastverhältnis des ersten Referenztaktsignals kleiner als das voreingestellte Tastverhältnis ist, Verkleinern der Amplitude des Ausgangssignals der Tastverhältnis-Detektionsschaltung durch die Tastverhältnis-Detektionsschaltung, wobei M eine ganze Zahl größer als 1 ist.

6. Schaltung nach Anspruch 4 oder 5, wobei, dass die Tastverhältnis-Detektionsschaltung das Tastverhältnis des ersten Referenztaktsignals erhält, Folgendes umfasst:
die Tastverhältnis-Detektionsschaltung ist ausgelegt zum Erhalten von Hochpegeldauer oder Niedrigpegeldauer des ersten Referenztaktsignals; und
die Tastverhältnis-Detektionsschaltung ist ausgelegt zum Bestimmen des Tastverhältnisses des ersten Referenztaktsignals auf der Basis einer Periode des ersten Referenztaktsignals und der Hochpegeldauer oder der Niedrigpegeldauer des ersten Referenztaktsignals.

7. Schaltung nach einem der Ansprüche 3 bis 5, wobei das voreingestellte Tastverhältnis 50% ist.

8. Schaltung nach Anspruch 3, wobei die Tastverhältnis-Kalibrationsschaltung ferner Folgendes umfasst:
eine Digital-Analog-Umsetzungsschaltung (1052), ausgelegt zum Umsetzen des Ausgangssignals der Tastverhältnis-Detektionsschaltung in eine zweite Referenzspannung und Eingeben der zweiten Referenzspannung in den zweiten rauscharmen, abfallarmen Regler, um die durch den zweiten rauscharmen, abfallarmen Regler ausgegebene erste Referenzspannung einzustellen.

9. Schaltung nach einem der Ansprüche 1 bis 8, wobei die Tastverhältnis-Regelungsschaltung einen ersten Transistor Q1 und einen zweiten Transistor Q2 umfasst;
ein Sourceanschluss des ersten Transistors Q1 mit der Tastverhältnis-Kalibrationsschaltung gekoppelt ist, sowohl ein Gate des ersten Transistors Q1 als auch ein Gate des zweiten Transistors Q2 mit der Oszillationsschaltung gekoppelt sind, sowohl ein Drainanschluss des ersten Transistors Q1 als auch ein Drainanschluss des zweiten Transistors Q2 mit der Tastverhältnis-Kalibrationsschaltung gekoppelt sind und ein Sourceanschluss des zweiten Transistors Q2 mit der Masse gekoppelt ist; und
wenn eine Sourcespannung des ersten Transistors Q1 zunimmt, das Tastverhältnis des ersten Referenztaktsignals abnimmt, und wenn die Sourcespannung des ersten Transistors Q1 abnimmt, das Tastverhältnis des ersten Referenztaktsignals zunimmt.

10. Schaltung nach einem der Ansprüche 1 bis 9, wobei die Tastverhältnis-Kalibrationsschaltung ferner Folgendes umfasst:
eine Frequenzverdopplungsschaltung, ausgelegt zum Umsetzen des ersten Referenztaktsignals in ein zweites Referenztaktsignal, wobei eine Frequenz des zweiten Referenztaktsignals zweimal die des ersten Referenztaktsignals ist.

## Revendications

1. Circuit d'étalonnage de rapport cyclique d'horloge de référence, comprenant :
un premier régulateur à faible chute de tension et à faible bruit (101), configuré pour fournir une tension à faible bruit ;
un circuit d'oscillation (102), configuré pour générer un signal sinusoïdal sous la commande de la tension à faible bruit ;
un circuit d'ajustement de rapport cyclique (103), configuré pour ajuster, sur la base d'une première tension de référence, un rapport cyclique d'un premier signal d'horloge de référence généré sur la base du signal sinusoïdal ; et
un circuit d'étalonnage de rapport cyclique (105), comprenant :
un circuit de détection de rapport cyclique (1053), configuré pour détecter le rapport cyclique du premier signal d'horloge de référence, et ajuster une amplitude d'un signal de sortie du circuit de détection de rapport cyclique sur la base du rapport cyclique du premier signal d'horloge de référence ; et
un second régulateur à faible chute de tension et à faible bruit (1051), configuré pour ajuster et sortir la première tension de référence sur la base de l'amplitude du signal de sortie du circuit de détection de rapport cyclique, dans lequel une valeur de la première tension de référence est directement proportionnelle à l'amplitude du signal de sortie du circuit de détection de rapport cyclique.

2. Circuit selon la revendication 1, dans lequel le signal sinusoïdal généré par le circuit d'oscillation est entré dans le circuit d'ajustement de rapport cyclique par couplage en courant continu.

3. Circuit selon la revendication 1 ou 2, dans lequel le fait que le circuit de détection de rapport cyclique ajuste l'amplitude du signal de sortie du circuit de détection de rapport cyclique sur la base du rapport cyclique du premier signal d'horloge de référence comprend que :
le circuit de détection de rapport cyclique est configuré pour détecter si le rapport cyclique du premier signal d'horloge de référence s'écarte d'un rapport cyclique prédéfini ; et
le circuit de détection de rapport cyclique est en outre configuré pour : lorsqu'il est déterminé que le rapport cyclique du premier signal d'horloge de référence s'écarte du rapport cyclique prédéfini, ajuster l'amplitude du signal de sortie du circuit de détection de rapport cyclique ; et lorsqu'il est déterminé que le rapport cyclique du premier signal d'horloge de référence ne s'écarte pas du rapport cyclique prédéfini, sauter l'ajustement de l'amplitude d'un signal de sortie du circuit de détection de rapport cyclique.

4. Circuit selon la revendication 3, dans lequel le fait que le circuit de détection de rapport cyclique soit configuré pour : lorsque le rapport cyclique du premier signal d'horloge de référence s'écarte du rapport cyclique prédéfini, ajuster l'amplitude du signal de sortie du circuit de détection de rapport cyclique comprend spécifiquement que :
lorsqu'il est détecté, pendant N fois consécutives, que le rapport cyclique du premier signal d'horloge de référence est supérieur au rapport cyclique prédéfini, augmenter, par le circuit de détection de rapport cyclique, l'amplitude du signal de sortie du circuit de détection de rapport cyclique, où N est un nombre entier supérieur à 1.

5. Circuit selon la revendication 3, dans lequel le fait que le circuit de détection de rapport cyclique soit configuré pour : lorsque le rapport cyclique du premier signal d'horloge de référence s'écarte du rapport cyclique prédéfini, ajuster l'amplitude du signal de sortie du circuit de détection de rapport cyclique comprend spécifiquement que :
lorsqu'il est détecté, pendant M fois consécutives, que le rapport cyclique du premier signal d'horloge de référence est inférieur au rapport cyclique prédéfini, diminuer, par le circuit de détection de rapport cyclique, l'amplitude du signal de sortie du circuit de détection de rapport cyclique, où M est un nombre entier supérieur à 1.

6. Circuit selon la revendication 4 ou 5, dans lequel le fait que le circuit de détection de rapport cyclique obtienne le rapport cyclique du premier signal d'horloge de référence comprend que :
le circuit de détection de rapport cyclique est configuré pour obtenir une durée de niveau haut ou une durée de niveau bas du premier signal d'horloge de référence ; et
le circuit de détection de rapport cyclique est configuré pour déterminer le rapport cyclique du premier signal d'horloge de référence sur la base d'une période du premier signal d'horloge de référence et de la durée de niveau haut ou de la durée de niveau bas du premier signal d'horloge de référence.

7. Circuit selon l'une quelconque des revendications 3 à 5, dans lequel le rapport cyclique prédéfini est de 50 %.

8. Circuit selon la revendication 3, dans lequel le circuit d'étalonnage de rapport cyclique comprend en outre :
un circuit de conversion numérique-analogique (1052), configuré pour : convertir le signal de sortie du circuit de détection de rapport cyclique en une seconde tension de référence, et entrer la seconde tension de référence dans le second régulateur à faible chute de tension et à faible bruit, pour ajuster la première tension de référence sortie par le second régulateur à faible chute de tension et à faible bruit.

9. Circuit selon l'une quelconque des revendications 1 à 8, dans lequel le circuit de régulation de rapport cyclique comprend un premier transistor Q1 et un second transistor Q2 ;
une source du premier transistor Q1 est couplée au circuit d'étalonnage de rapport cyclique, une grille du premier transistor Q1 et une grille du second transistor Q2 sont toutes deux couplées au circuit d'oscillation, un drain du premier transistor Q1 et un drain du second transistor Q2 sont tous deux couplés au circuit d'étalonnage de rapport cyclique, et une source du second transistor Q2 est couplée à la masse ; et lorsqu'une tension de source du premier transistor Q1 augmente, le rapport cyclique du premier signal d'horloge de référence diminue, et lorsque la tension de source du premier transistor Q1 diminue, le rapport cyclique du premier signal d'horloge de référence augmente.

10. Circuit selon l'une quelconque des revendications 1 à 9, dans lequel le circuit d'étalonnage de rapport cyclique comprend en outre :
un circuit de doublage de fréquence, configuré pour convertir le premier signal d'horloge de référence en un second signal d'horloge de référence, dans lequel une fréquence du second signal d'horloge de référence est deux fois celle du premier signal d'horloge de référence.
